# EUROPEAN PATENT APPLICATION

(11) **EP 1 437 831 A2**
(43) Date of publication of application: **14.07.2004**
(21) Application number: 04000020.0
(22) Date of filing: 02.01.2004
(51) Int. Cl.: H03M 1/10

(54) **D/a conversion apparatus with offset compensation function and d/a conversion apparatus offset compensation method**

(30) Priority: 10.01.2003 JP 2003004041
(71) Applicant: MATSUSHITA ELECTRIC INDUSTRIAL CO., LTD., Kadoma-shi, Osaka 571-8501 (JP)
(72) Inventor: Ito, Minoru, Shiga-gun Shiga 520-0532 (JP)
(74) Representative: Grünecker, Kinkeldey, Stockmair & Schwanhäusser Anwaltssozietät

(57) **Abstract**

An input changeover switch 40 is provided ahead of a comparator 50 that measures the DC offset of a D/A converter 30, and a selective polarity inverter 60 is provided after comparator 50. A first compensation value is generated by a compensation value generation section 12 and stored in a register 18. Next, changeover switch 40 and polarity inverter 60 are switched and a second compensation value is generated, and is stored in a register 20. Then an average compensation value is calculated by finding the arithmetic mean of the first and second compensation values by means of an average compensation value computation circuit 22, and the input data is corrected with this average compensation value.

## Description

### BACKGROUND OF THE INVENTION

### 1. Field of the Invention

The present invention relates to a D/A conversion apparatus with an offset compensation function and a D/A conversion apparatus offset compensation method.

### 2. Description of the Related Art

In digitalradiocommunicationequipment,digitally modulated I (positive-phase) and Q (orthogonal) signals undergo D/A conversion, are combined in the radio frequency section of a radio telephone, and sent to an antenna as a radio signal. Ideally, the analog output voltage of a D/A converter would match an ideal output voltage corresponding to the digital input value (an analog output voltage that has no DC offset), but in reality, for various reasons DC offset occurs between the actual output and the ideal output.

In the case of a differential output D/A converter, when DC offset occurs between the D/A converter differential outputs corresponding to the I signal and Q signal (I+ and I-, or Q+ and Q-) (that is, when the D/A converter's differential output input/output characteristics are different), phase shift arises between the I and Q signals, resulting in transmission error.

It is therefore necessary to cancel DC offset between D/A converter differential outputs and adjust the D/A converter's characteristics.

In order to cancel DC offset between A/D converter differential outputs, it is first necessary to measure DC offset between D/A converter differential outputs for test data in a test mode - a state in which there are no input signals. A comparator (voltage comparison device) is used for this purpose.

Conventionally, +1 (high level) or -1 (low-level), obtained based on the result of voltage comparison by the comparator, is added to a compensation value (with an initial value of 0), and then the compensation value is subtracted from the test data to give the next D/A converter digital input. This procedure is then repeated until the polarity of the comparator changes. A technology whereby the compensation value at the time at which the polarity changes becomes the compensation value (control data) for compensating for DC offset between D/A converter differential outputs, and DC offset between D/A converter differential outputs is canceled by correcting the input data using this value, is described in patent documentation (Unexamined Japanese Patent Publication No.HEI 7-202693 (FIG.1, FIG.2, etc.)).

Actually, DC offset is also present in a comparator that detects D/A converter DC offset in a single output type D/A conversion apparatus, and in a comparator that detects DC offset between D/A converter differential outputs in a differential output type D/A conversion apparatus. Normally, comparator DC offset is designed to be kept within several mV.

However, investigation by the present inventors has confirmed that there are cases in which DC offset of a comparator itself is 20 mV or higher due to transistor size, variations in LSI structural process conditions, and so forth. In particular, there is a tendency for comparator DC offset to increase as transistor sizes become smaller.

The DC offset of a comparator constitutes error when D/A converter DC offset (including DC offset between differential outputs) ismeasured. Thus, if the DC offset of a comparator itself is large, accurate measurement is not possible, and D/A converter DC offset cannot be completely eliminated.

### SUMMARY OF THE INVENTION

It is an object of the present invention to provide a D/A conversion apparatus with an offset compensation function and a D/A conversion apparatus offset compensation method that make it possible to almost completely eliminate D/A converter DC offset even when DC offset is present in a comparator.

According to an aspect of the invention, a D/A conversion apparatus with an offset compensation function detects D/A converter DC offset using a comparator, finds a compensation value based on the output signal of the comparator, corrects input data by performing addition or subtraction of the compensation value to/from the input data, and thereby compensates for the DC offset; and this D/A conversion apparatus with an offset compensation function has:
a changeover switch for selecting a first input mode in which a first and second signal respectively are input to a first and second input terminal of the comparator, and a second input mode in which the second and first signals respectively are input to the first and second input terminals of the comparator;
a polarity inversion section that inverts the polarity of the comparator output signal only when the second input mode is selected by means of this changeover switch; and
an input data correction section that in the first input mode finds a first compensation value based on the comparator output signal, in the second input mode finds a second compensation value based on a signal resulting from inversion of the comparator output signal by the polarity inversion section, then finds an average compensation value by calculating the average of the first and second compensation values, and also performs correction of the input data using the calculated average compensation value.

According to another aspect of the invention, a D/A conversion apparatus with an offset compensation function detects D/A converter DC offset using a comparator, finds a compensation value based on the output signal of the comparator, corrects input data by performing addition or subtraction of the compensation value to/ from the input data, and thereby compensates for the DC offset; and this D/A conversion apparatus with an offset compensation function uses as the comparator a self-compensating comparator that has a function that cancels DC offset of this comparator itself;
wherein this self-compensating comparator has:
an operational amplifier;
a buffer or inverter;
a first switch for switching between connection and disconnection between the output terminal and inverse terminal of this operational amplifier;
a capacitor of which one side is connected to the inverse terminal of this operational amplifier; and
a second switch for switching between connection and disconnection between another output of this capacitor and a non-inverse terminal of the operational amplifier.

According to still another aspect of the invention, a D/A conversion apparatus offset compensation method detects D/A converter DC offset using a comparator, finds a compensation value based on the output signal of the comparator, corrects input data by performing addition or subtraction of the compensation value to/from the input data, and thereby compensates for the DC offset; and this D/A conversion apparatus offset compensation method has:
a step of inputting a first and second signal respectively to a first and second input terminal of the comparator, and finding a first compensation value based on the comparator output signal;
a step of inputting the second and first signal respectively to the first and second input terminal of the comparator, and finding a second compensation value based on a signal resulting from inversion of the comparator output signal by the polarity inversion section;
a step of finding an average compensation value by calculating the average of the first and second compensation values; and
a step of performing correction of the input data using this average compensation value.

### BRIEF DESCRIPTION OF THE DRAWINGS

The above and other objects and features of the invention will appear more fully hereinafter from a consideration of the following description taken in conjunction with the accompanying drawing wherein one example is illustrated by way of example, in which:
FIG.1 is a drawing for explaining the configuration and operation (first compensation value generation operation) of a D/A conversion apparatus with an offset compensation function (in which the D/A converter has a differential output configuration) according to Embodiment 1 of the present invention;
FIG.2 is a drawing for explaining the operation (second compensation value generation operation) of a D/A conversion apparatus with an offset compensation function, corresponding to Embodiment 1;
FIG.3 is a drawing for explaining the operation (average compensation value generation operation) of a D/A conversion apparatus with an offset compensation function, corresponding to Embodiment 1;
FIG.4 is a drawing for explaining the operation (operation whereby D/A conversion is performed while D/A converter DC offset is compensated for using an average compensation value) of a D/A conversion apparatus with an offset compensation function, corresponding to Embodiment 1;
FIG.5A is a drawing showing the DC offset compensation value when there is no DC offset in the comparator in FIG.4;
FIG.5B is a drawing showing an example of differential output of the D/A converter in FIG.5A;
FIG.5C is a drawing showing the DC offset compensation value before input switching (at the time of non-crossing input) when there is DC offset in the comparator in FIG.4;
FIG.5D is a drawing showing an example of an addition value and subtraction value for canceling the comparator DC offset in FIG.5D;
FIG.5E is a drawing showing the DC offset compensation value after input switching (at the time of crossing input) when there is DC offset in the comparator in FIG.4;
FIG. 5F is a drawing showing an example of an addition value and subtraction value for canceling the comparator DC offset in FIG.5E;
FIG.5G is a drawing showing that a DC offset compensation value based on an average compensation value is the same as a DC offset compensation value measured by a comparator with no DC offset (in the case of FIG.5A) , corresponding to Embodiment 1;
FIG.6 is a drawing for explaining the reason why DC offset can be canceled in the D/A conversion apparatus with an offset compensation function in FIG.4;
FIG.7 is a drawing for explaining the configuration of a D/A conversion apparatus with an offset compensation function (in which the D/A converter has a single output configuration) according to Embodiment 2 of the present invention;
FIG.8A is a drawing showing the DC offset compensation value when there is no DC offset in the comparator in FIG.7;
FIG.8B is a drawing showing the DC offset compensation value before input switching (at the time of non-crossing input) when there is DC offset in the comparator in FIG.8A;
FIG.8C is a drawing showing the DC offset compensation value after input switching (at the time of crossing input) when there is DCoffset inthe comparator in FIG.8A;
FIG.8D is a drawing showing that a DC offset compensation value based on an average compensation value is the same as a DC offset compensation value measured by a comparator with no DC offset (in the case of FIG.8A) ;
FIG. 9 is a drawing showing the overall configuration of a D/A conversion apparatus with an offset compensation function in which an offset compensation function is provided for the comparator itself according to Embodiment 3 of the present invention;
FIG. 10 is a circuit diagram for explaining the actual configuration and operation (operation of generating a voltage corresponding to the comparator DC offset on both sides of a capacitor) of a D/A conversion apparatus with an offset compensation function, corresponding to Embodiment 3;
FIG. 11 is a circuit diagram for explaining the actual configuration and operation (operation of measuring D/A converter DC offset while canceling comparator DC offset) of a D/A conversion apparatus with an offset compensation function, corresponding to Embodiment 3;
FIG.12A is a drawing showing DC offset arising in differential output of a D/A converter, corresponding to Embodiment 3;
FIG.12B is a drawing showing the potential of different parts when an operational amplifier with no DC offset has a voltage following configuration, corresponding to Embodiment 3;
FIG.12C is a drawing showing a mode in which a capacitor is connected to the inverse terminal of an operational amplifier with a voltage following configuration, corresponding to Embodiment 3;
FIG.13A is a drawing showing an operational amplifier with DC offset, corresponding to Embodiment 3;
FIG.13B is a drawing showing the state of the differential circuit in the operational amplifier with DC offset in FIG.13A;
FIG.13C is a drawing showing the potential of different parts of an operational amplifier and the state of the differential circuit in the operational amplifier when using a voltage following configuration, corresponding to Embodiment 3;
FIG.13D is a drawing showing the potential of different parts when a capacitor is connected to the inverse terminal of the operational amplifier with a voltage following configuration in FIG.13C;
FIG.13E is a drawing showing the output voltage when the analog voltage input to the inverse terminal of an operational amplifier is corrected, and that corrected voltage is supplied to the operational amplifier, corresponding to Embodiment 3;
FIG.13F is a drawing showing the output voltage when the output of the operational amplifier in FIG.13E is inverted by an inverter;
FIG.14A is a drawing showing the circuit configuration when there is no DC offset compensation function in a comparator for measuring DC offset between D/A converter differential outputs, corresponding to Embodiment 3;
FIG. 14B is a drawing showing the potential of outputs A+ and A- before compensation value measurement, and the potential of outputs A+ and A- after compensation value measurement, in the D/A converter in FIG.14A;
FIG.14C is a drawing showing the circuit configuration when there is a DC offset compensation function in a comparator for measuring DC offset between D/A converter differential outputs, corresponding to Embodiment 3;
FIG. 14D is a drawing showing the potential of outputs A+ and A- and the potential of the operational amplifier inputs before compensation value measurement, and the potential of the operational amplifier inputs after compensation value measurement, in the D/A converter in FIG.14A;
FIG.15 is a drawing showing the overall configuration of a D/A conversion apparatus with an offset compensation function in which an offset compensation function is provided for the comparator itself according to Embodiment 4 of the present invention;
FIG.16A is a drawing showing the circuit configuration when there is no DC offset compensation function in a comparator for measuring D/A converter DC offset, corresponding to Embodiment 4;
FIG.16B is a drawing showing the output potential before compensation value measurement and the output potential after compensation value measurement in the D/A converter in FIG.16A;
FIG.16C is a drawing showing the circuit configuration when there is a DC offset compensation function in a comparator for measuring D/A converter DC offset, corresponding to Embodiment 4; and
FIG.16D is a drawing showing the output potential before compensation value measurement, the potential of the operational amplifier inputs, and the potential of the operational amplifier inputs after compensation value measurement, in the D/A converter in FIG.16C;
FIG.17 is a block diagram showing the configuration of a digital radio transmitter equipped with a D/A conversion apparatus with an offset compensation function (in an LSI implementation) according to Embodiment 5 of the present invention.

### DESCRIPTION OF THE PREFERRED EMBODIMENTS

With reference now to the accompanying drawings, embodiments of the present invention will be explained in detail below.

### (Embodiment 1)

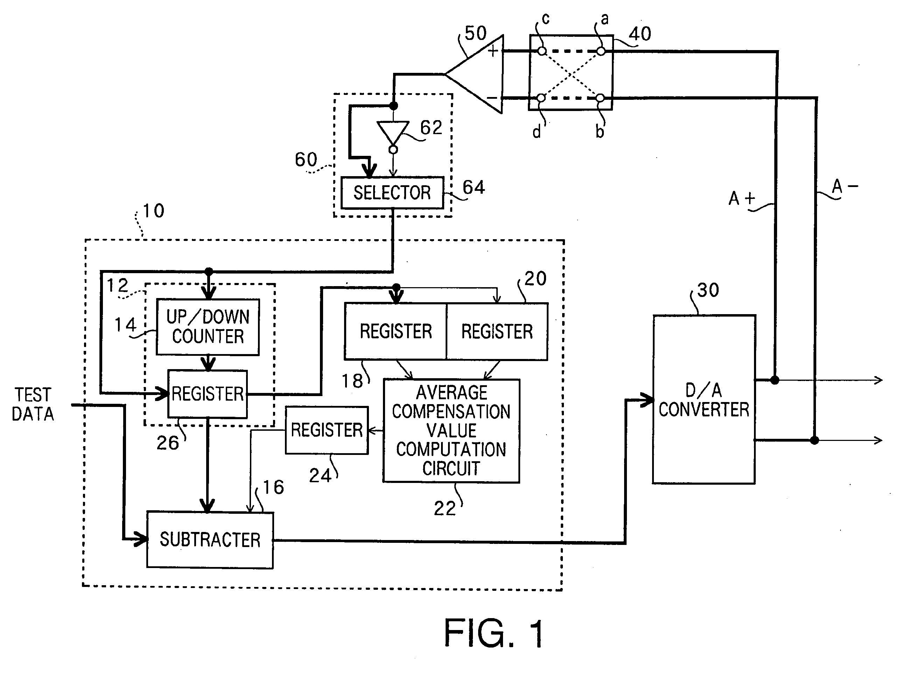

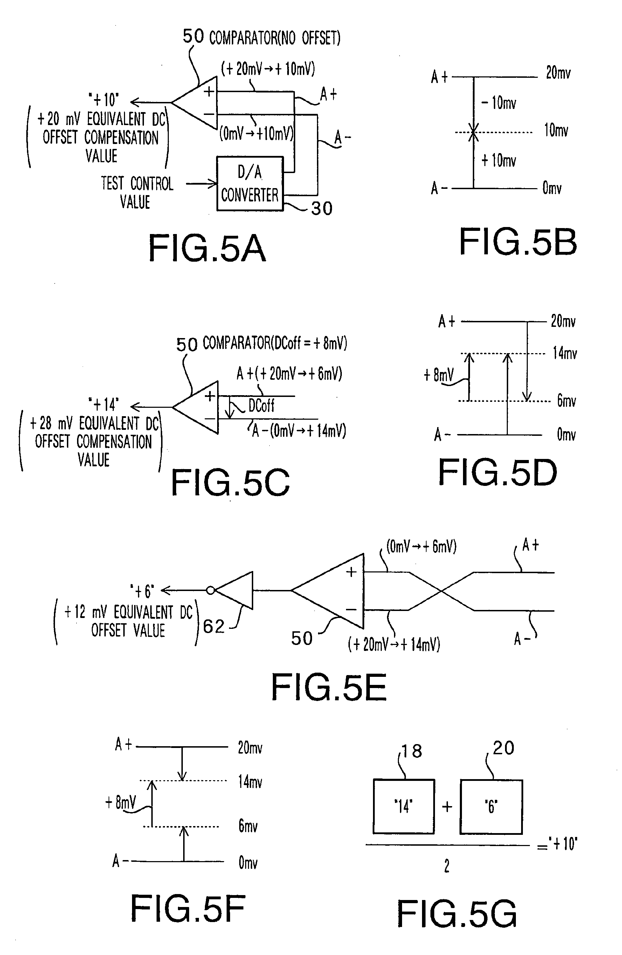

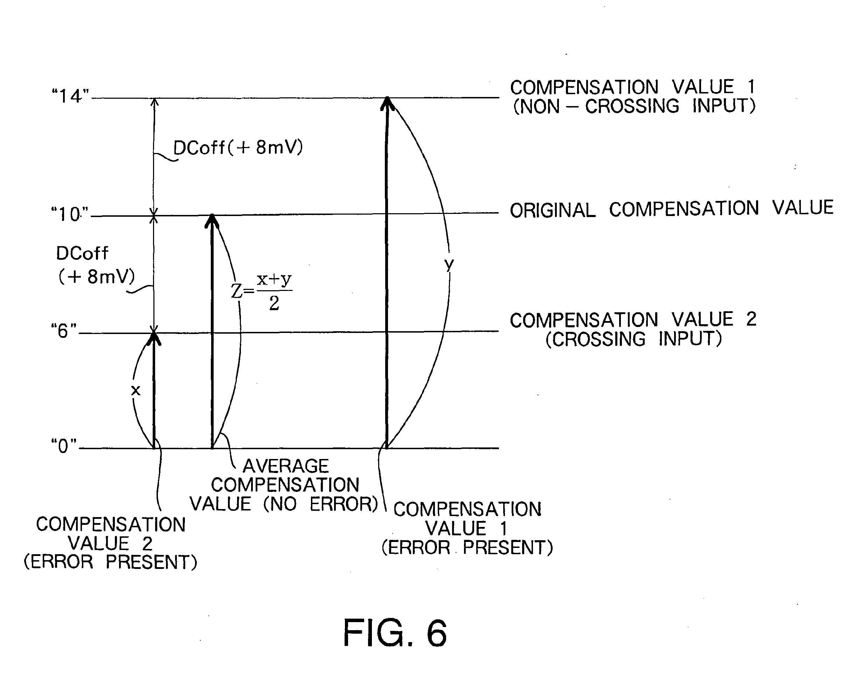

FIG.1 through FIG.4 are block diagrams for explaining the configuration and operation of a D/A conversion apparatus with an offset compensation function according to Embodiment 1 of the present invention, and FIG.5 and FIG.6 are drawings for explaining the reason why DC offset of the comparator itself is canceled.

First, the configuration of a D/A conversion apparatus with an offset compensation function will be described using FIG.1.

As shown in the figure, the D/A conversion apparatus has an input data correction section 10, a D/A converter 30 with a differential output configuration, a comparator 50, an input changeover switch 40 provided ahead of this comparator, and a polarity inverter 60 (comprising an inverter 62 and selector 64) for selectively inverting the polarity of the comparator 50 output signal. A low-pass filter may also be incorporated in D/A converter 30.

Input data correction section 10 has a compensation value generation section 12 (essentially composed of a counter 14 and register 26), two registers 18 and 20 for temporarily storing a first compensation value and second compensation value, an average compensation value computation circuit 22, a register 24 for storing the average compensation value computation result, and a subtracter 16 that subtracts a compensation value from the input data.

In this D/A conversion apparatus with an offset compensation function, the fact that comparator 50 itself has DC offset is taken into consideration, and total DC offset including the DC offset between the differential outputs of D/A converter 30 and the DC offset of comparator 50 itself is corrected by means of negative feedback control.

Next, the operation for compensating for DC offset will be described.

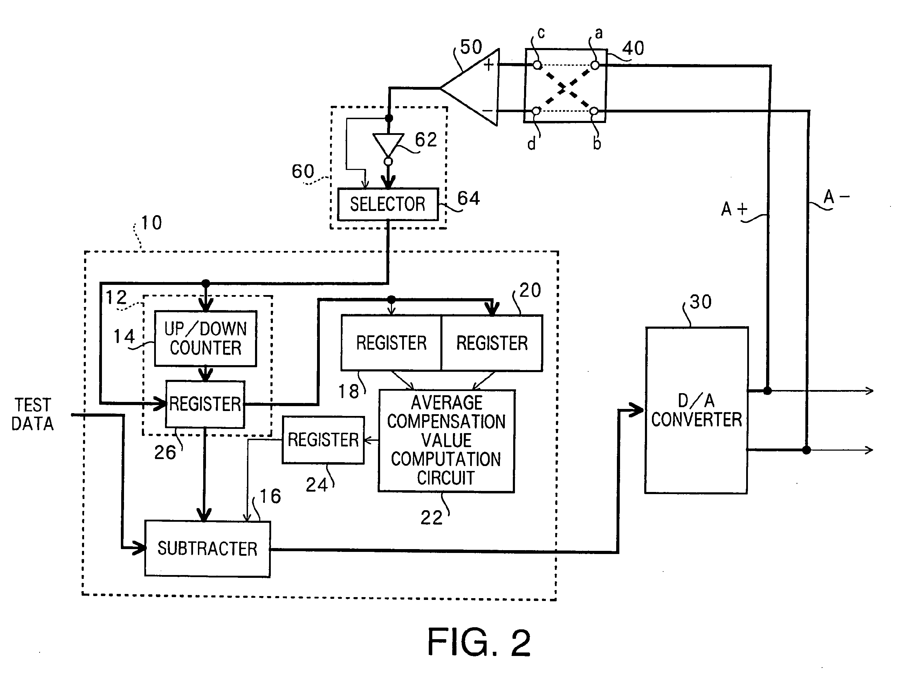

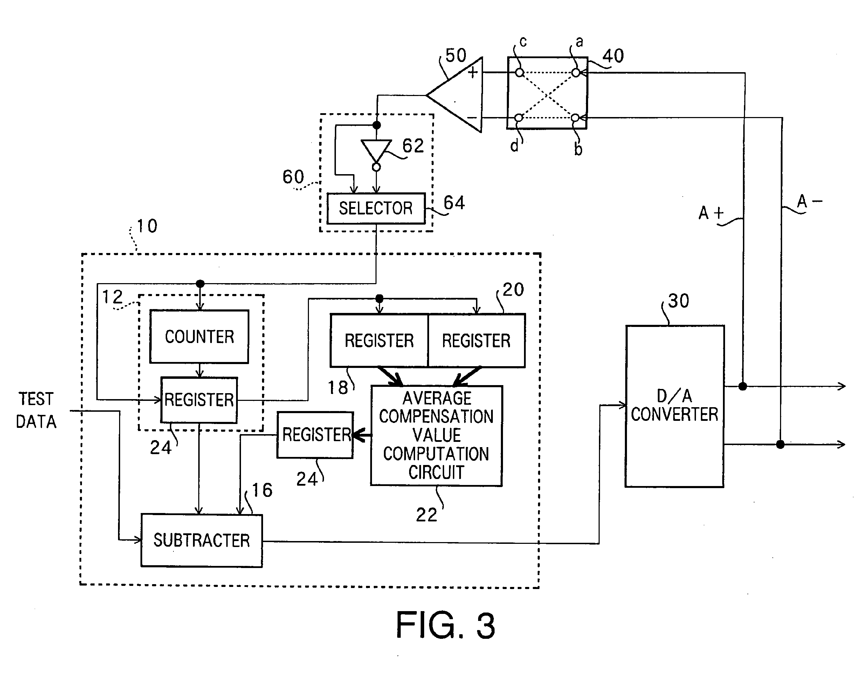

This operation is broadly divided into a stage in which a first compensation value is found in a test mode in which there is no signal to be sent on a radio path (FIG.1), a stage in which a second compensation value is found (FIG.2), and a stage in which an average compensation value is found (FIG.3).

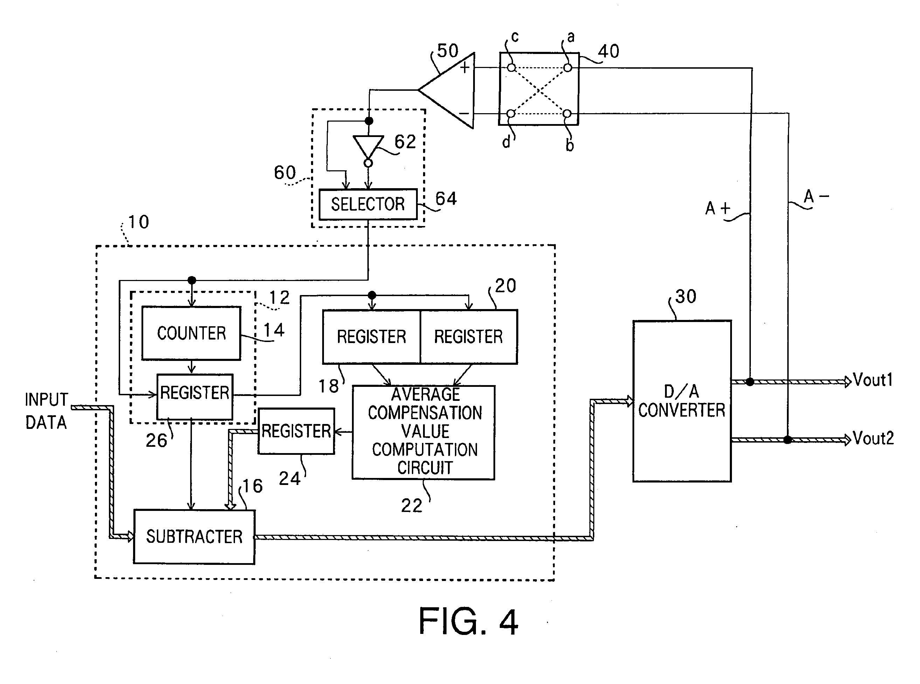

Then, as shown in FIG.4, the DC offset between the differential outputs of D/A converter 30 can be eliminated by correcting normal input data using the found average compensation value.

A detailed description will now be given.

In FIG.1, the operation (procedure) whereby a first compensation value is found in the test mode is indicated by bold lines.

First, test data (for example, digital input data corresponding to D/A converter 30 analog 0 V output (a value approximately intermediate between VDD and VSS)) is supplied to input data correction section 10.

Simultaneously with this, counter 14 starts operating. Counter 14 is incremented when the output of polarity inverter 60 connected to comparator 50 is +1 (high level), and is decremented when the output of polarity inverter 60 is -1 (low level). The count value is stored in register 26. It is here assumed that the count value of compensation value generation section 12 is used directly as a compensation value.

Initially, the count value of compensation value generation section 12 is zero, and therefore the supplied test data is output unchanged from subtracter 16, and is supplied to D/A converter 30 with a differential output configuration.

Complementary outputs with phases differing by 180° are obtained from D/A converter 30. These two output signals are designated "A+" and "A-". A+ is a positive-phase output, and A- a negative-phase output, with respect to the digital input data. These signals are input to comparator 50 via changeover switch 40.

As shown in the figure, changeover switch 40 has a function of selectively connecting input terminals a and b to output terminals c and d.

In changeover switch 40 in FIG.1, terminal a and terminal c are connected, and terminal b and terminal d are connected. In this state, a first input mode is selected.

In this first input mode, selector 64 in polarity inverter 60 passes the output signal from comparator 50 unchanged.

The comparator 50 output signal is supplied to counter 14 and register 26 functioning as compensation value generation section 12.

Counter 14 is incremented when this supplied comparator 50 output signal is +1 (high level) and decremented when the signal is -1 (low level). The count value is stored in register 26.

Subtracter 16 subtracts the register 26 value (count value) from the test data, and the resultant output is input to D/A converter 30 as the next digital input value.

Thereafter, the same operations are performed by looping, and these operations continue until the polarity of the comparator 50 output signal is inverted.

That is to say, on detecting inversion of the polarity of the comparator 50 output signal, compensation value generation section 12 saves the count value at that time (this being the first compensation value) in register 18.

Detection of polarity inversion must be carried out carefully, taking account of minute swings of the input voltage.

Next, as shown in FIG.2, changeover switch 40 is controlled so that terminal a and terminal d are connected, and terminal b and terminal c are connected. In this state, a second input mode is selected.

At this time, selector 64 of polarity inverter 60 selects the output signal of inverter 62. That is to say, a signal with the polarity of comparator 50 output signal inverted is supplied to counter 14 and register 26.

In this state, the compensation value generation section 12 count value is restored to zero, and either the same operation as in FIG. 1 is performed, or an operation is performed to then find the second compensation value from the same count value as the first compensation value found in the operation in FIG.1. The second compensation value obtained as a result is stored in register 20.

Then, as shown in FIG.3, the first and second compensation values are fetched from register 18 and register 20, average compensation value computation circuit 22 calculates an average compensation value by performing an arithmetic mean operation, and this average compensation value is stored in register 24.

This average compensation value is the compensation value when comparator 50 has no offset whatever (that is to say, a compensation value whereby DC offset based on accurate measurement of DC offset between the differential outputs of D/A converter 30 can be completely canceled).

Therefore, DC offset between the differential outputs of D/A converter 30 can be completely eliminated by correcting normal input data using an obtained average compensation value, as shown in FIG.4. The reason why the offset of comparator 50 itself is completely masked and made indiscernible by the above-described method will now be explained in detail using FIG.5 and FIG.6. It is here assumed that the minimum resolution (LSB) of the D/A converter is 1 mV.

In FIG.5A, a case is assumed in which comparator 50 has no DC offset whatever.

When test data (test control value: data corresponding to 0 V) is supplied to D/A converter 30, since D/A converter differential outputs A+ and A- are mutually independent, if there happens to be DC offset in the D/A converter it appears as DC offset between the differential outputs. It is here assumed that, of the complementary outputs of D/A converter 30, the voltage of A+ is 20 mV and the voltage of A- is 0 mV.

Properly, the two outputs should both be 0 mV. In this case, therefore, 20 mV DC inter-differential-output DC offset has arisen.

Next, what kind of compensation value is necessary to cancel this 20 mV offset (how big a value should be used for the compensation value) will be considered.

The point to be noted here is that, in the case of a differential output type D/A converter, for a "+1" compensation value, -1 mV correction is performed for A+, and conversely, 1 mV correction is performed for A-.

That is to say, in the case of a differential output type D/A converter, for a "+1" compensation value, a total correction of -2 mV is applied between A+ and A-.

As stated above, there is now a 20 mV inter-differential-output DC offset between A+ and A-. Therefore, as shown in FIG.5B, this offset can be canceled by performing correction so that 10 mV is subtracted from A+ (20 mV) and 10 mV is added to A- (0 V) (that is to say, by performing 10 mV correction when A+ and A- are considered individually).

Therefore, the necessary compensation value is "+10".

Here, comparator 50 has DC offset, as shown in FIG.5C (DC offset is here assumed to be such that the inverse terminal voltage is in effect 8 mV higher than the non-inverse terminal voltage).

In this case, the comparator 50 DC offset of 8 mV is added to the original D/A converter 30 inter-differential-output DC offset of 20 mV, and the DC offset is increased to 28 mV.

As shown in FIG.5D, this 28 mV DC offset can be canceled by performing correction so that 14 mV is subtracted from A+ (20 mV) and 14 mV is added to A- (0 V).

Therefore, the necessary compensation value (first compensation value) is "+14".

Next, the input to comparator 50 is switched as shown in FIG.5E.

A+ (which has become +20 mV due to the effect of the D/A converter 30 DC offset) is thus input to the inverse terminal of comparator 50, and A- (0 mV) is input to the non-inverse terminal of comparator 50.

As a result, the comparator 50 DC offset of 8 mV is subtracted from the original D/A converter 30 inter-differential-output DC offset of 20 mV, giving 12 mV, and error is reduced. However, as -12 mV (= (-20 mV + 8mV)) is applied as comparator 50 input, the polarity of comparator 50 output actually becomes negative. Thus, the polarity is inverted by inverter 62, and the compensation value is calculated.

As shown in FIG.5F, this 12 mV DC offset can be canceled by performing correction so that 6 mV is subtracted from A+ (20 mV) and 6 mV is added to A- (0 V).

Thus, the compensation value (second compensation value) is "+6".

Then, the arithmetic mean of the first compensation value and second compensation value is calculated, giving the average compensation value (= "+10"), as shown in FIG.5G.

The value of this average compensation value matches the compensation value (= "+10") obtained when comparator 50 has no DC offset at all, in FIG.5A.

That is to say, the DC offset of comparator 50 itself is masked and made indiscernible, D/A converter 30 inter-differential-output DC offset is measured accurately, and based on this an accurate compensation value is obtained.

In other words, the D/A converter 30 inter-differential-output DC offset compensation value is "+10", and whereas before comparator 50 input switching the DC offset compensation value of comparator 50 itself (= "+4") is added to this original DC offset, after input switching the DC offset compensation value of comparator 50 itself (= "+4") is subtracted.

That is to say, the polarity of the DC offset of comparator 50 itself is inverted after input switching as compared with before input switching.

On the other hand, the polarity of the original inter-differential-output DC offset (= +20 mV) of D/A converter 30 is the same before and after input switching. That is to say, after input switching, the output value polarity is reversed, but as this is inverted by inverter 62, the measured inter-differential-output DC offset compensation value remains at "+10".

Therefore, when the first compensation value (compensation value 1) and second compensation value (compensation value 2) are added, the DC offset component of comparator 50 is canceled, and on the other hand the original inter-differential-output DC offset component of D/A converter 30 is doubled, so that by dividing this by 2, a compensation value corresponding to only the original inter-differential-output DC offset component of D/A converter 30 is obtained.

The principle of this DC offset cancellation is shown in easily understood form in FIG.6.

If the original DC offset compensation value between differential outputs A+ and A- of D/A converter 30 is designated Voff, then Voff is "+10 (+20 mV equivalent)" as explained above.

Before comparator 50 input switching (in the case of non-crossing input), comparator 50 offset DCoff (= +8 mV) is added. If the first compensation value (compensation value 1) is designated y, then y is "+14".

On the other hand, after comparator 50 input switching (in the case of crossing input), comparator 50 offset DCoff (= +8 mV) is subtracted. If the second compensation value is designated x, then x is "+6".

Here, x+y = 2Voff.

Therefore, (x+y)/2 = Voff = z, and this average compensation value z is the compensation value corresponding to the original inter-differential-output DC offset.

### (Embodiment 2)

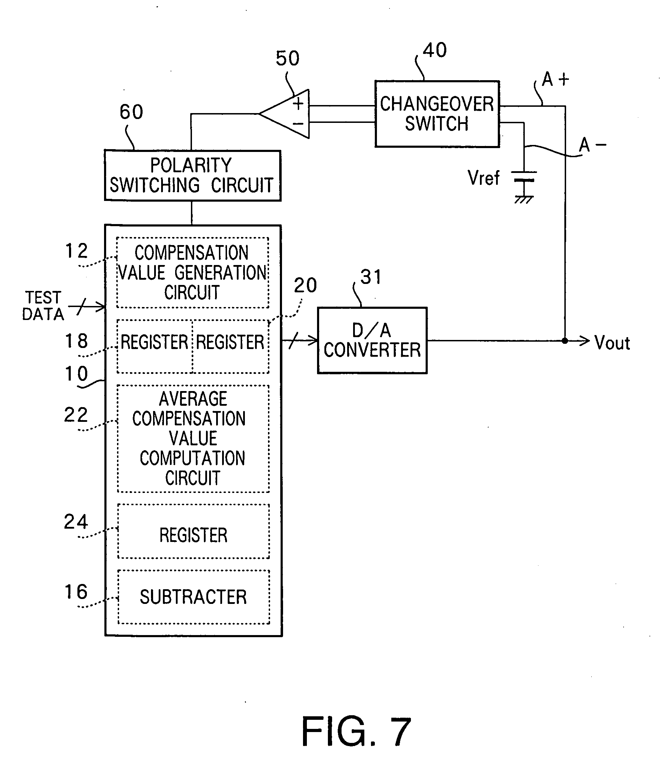

FIG.7 shows an example in which the present invention is used for offset compensation for a single output type D/A converter 31.

One input (A+) of changeover switch 40 is the D/A converter 31 output signal, and the other input (A-) is a reference voltage (corresponding to the output voltage of an ideal D/A converter).

The remaining configuration is the same as that described above, and parts identical to those in the previously described example are assigned the same codes .

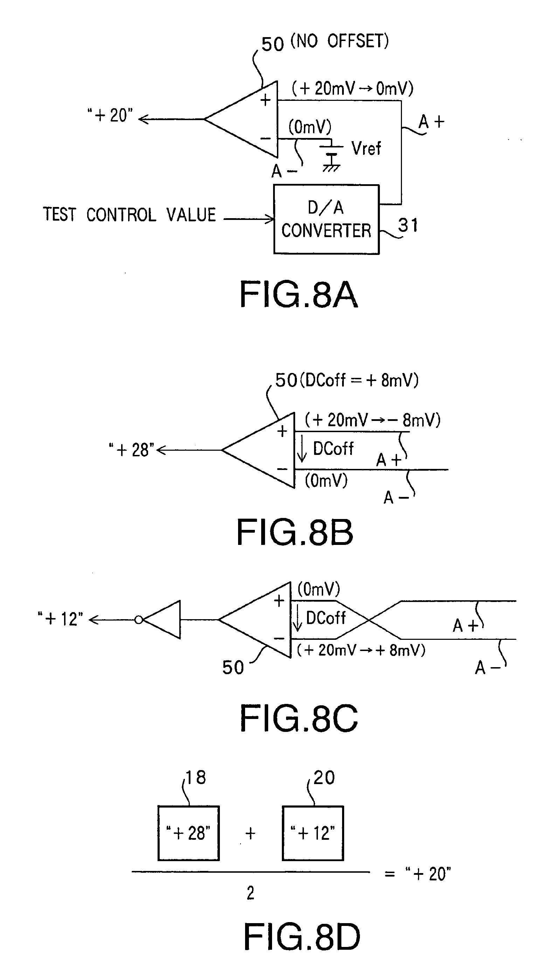

The characteristic operation of this embodiment is illustrated in FIGS.8A through 8D. The operation is fundamentally the same as that described using FIG.5. Here, too, assuming that the minimum resolution (LSB) of D/A converter 31 is 1 mV, in the case of single output type D/A converter 31, correction of -1 mV is applied only to A+ for a compensation value of "+1". That is to say, the compensation value of a single output type D/A conversion apparatus is twice the compensation value of a differential output type D/A conversion apparatus.

That is to say, FIG.8A shows the D/A converter 31 DC offset compensation value when there is no DC offset in comparator 50, FIG.8B shows the D/A converter 31 DC offset compensation value (corresponding to the first compensation value) before input switching when there is DC offset in comparator 50, FIG.8C shows the D/A converter 31 DC offset compensation value (corresponding to the second compensation value) after input switching when there is DC offset in comparator 50, and FIG. 8D shows that the average compensation value obtained by averaging the first and second compensation values matches the compensation value obtained in the case of FIG.8A.

### (Embodiment 3)

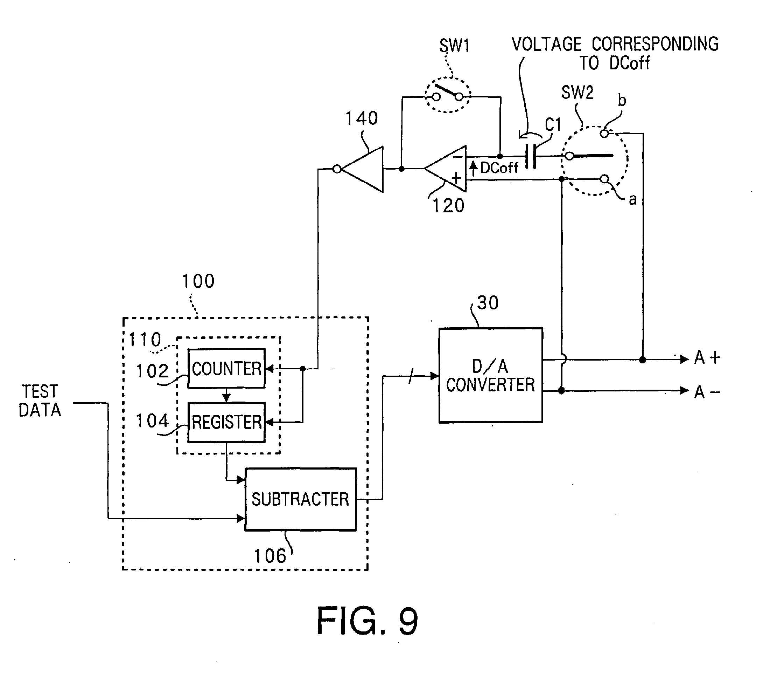

FIG.9 is a block diagram showing an example of the configuration of a D/A conversion apparatus with an offset compensation function in which an operational amplifier 120 and inverter 140 are used instead of a comparator, and an offset compensation function is provided for operational amplifier 120 itself (that is to say, a self-compensating operational amplifier is used).

In this embodiment, D/A converter 30 inter-differential-output DC offset compensation is performed by means of input data compensation after DC offset of operational amplifier 120 is canceled by means of an analog technique using a capacitor C1.

In the previous embodiments, operational amplifier DC offset can be seen to be eliminated when viewing the overall system, but this embodiment differs in that operational amplifier 120 itself has an offset cancellation function, and is a self-compensating operational amplifier.

However, a point in common is that DC offset of the operational amplifier itself is canceled using information on DC offset of the operational amplifier.

First, the overall configuration of the D/A conversion apparatus in FIG.9 will be described.

As shown in the figure, input data correction section 100 has a compensation value generation section 110 (comprising a counter 102 and register 104), and a subtracter 106.

As in the previous embodiments, the counter 102 count value is used directly as a compensation value via register 104.

Register 104 also has a function of storing the counter value when the polarity of the operational amplifier 120 output signal is inverted.

In this embodiment, a complementary output type (differential output type) D/A converter 30 is used.

Also provided are a first switch (SW1) that switches between connection and disconnection between the output terminal and inverse input terminal of operational amplifier 120 that has an offset cancellation function, and a capacitor C1 one side of which is connected to the inverse input terminal of operational amplifier 120, and the other side of which is connected to a second switch (SW2).

The second switch is provided on the other side of capacitor C1 in order to switch between supplying the output A- voltage to the b terminal side constituting one side of D/A converter 30 and supplying the output A+ voltage to the a terminal side constituting the other side.

The non-inverse input terminal of operational amplifier 120 is connected to above-mentioned terminal a, and the operational amplifier 120 output terminal is connected to the input terminal of inverter 140. The inverter 140 output terminal is connected to counter 102 and register 104.

In this embodiment, first, the second switch (SW2) is switched to the terminal a side, the first switch (SW1) is turned on, and operational amplifier 120 is given a voltage following configuration, whereby a voltage corresponding to the operational amplifier 120 DC offset is generated on both sides of capacitor C1.

Next, the first switch (SW1) is turned off, and the operational amplifier 120 is restored to a comparator configuration. Then the second switch (SW2) is switched to the terminal b side. Then, when in the test mode, an inter-differential-output DC offset occurs between A+ and A-. Therefore, a voltage resulting from adding a voltage corresponding to the operational amplifier 120 DC offset to the inter-differential-output DC offset of D/A converter 30 is input between the operational amplifier 120 input terminals.

By this means, the voltage input to the inverse terminal of operational amplifier 120 is corrected by the amount of operational amplifier 120 DC offset.

Therefore, the operational amplifier 120 DC offset is canceled. Thus, the DC offset between the D/A converter 30 differential outputs can be measured accurately.

The procedure will now be described in detail. First, in the circuit in FIG.9, when test data is input an analog voltage corresponding to the test data is generated in D/A converter 30 outputs A+ and A-.

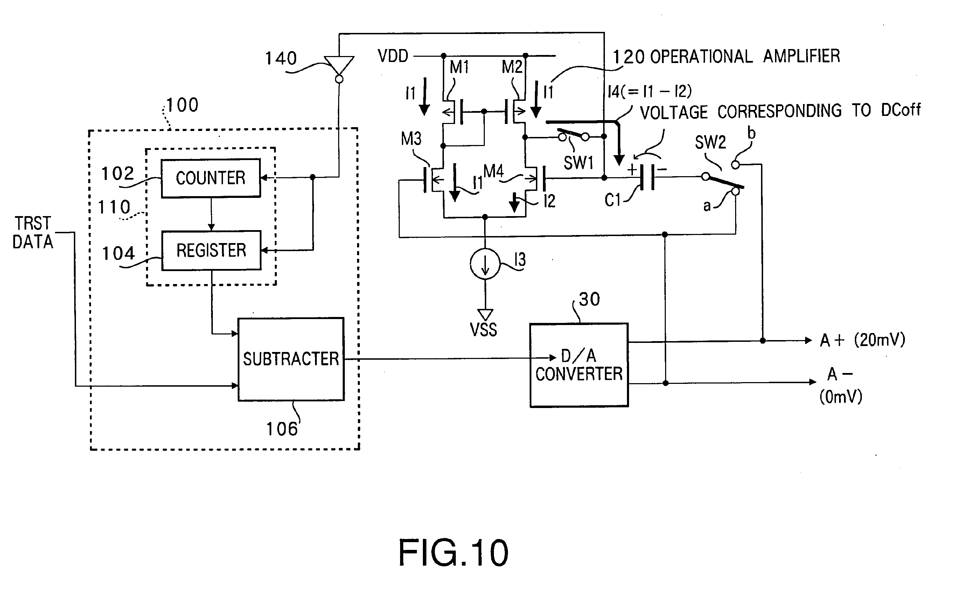

FIG.10 is a drawing for explaining in detail the operation whereby a voltage corresponding to the operational amplifier 120 DC offset is generated on both sides of capacitor C1.

As shown in the figure, operational amplifier 120 is composed of NMOS transistors (M3 and M4) , current mirror loads (M1 and M2), and a constant current source I3.

In FIG.10, first switch SW1 is turned on, giving a voltage following configuration. Second switch SW2 is switched to the terminal a side.

The voltage of A-, one of the outputs of D/A converter 30, is supplied to the gate of NMOS transistor M3 and terminal a on the switch SW2 side of capacitor C1.

As operational amplifier 120 has a voltage following configuration, the voltages of the inverse terminal (gate of NMOS transistor M4), non-inverse terminal (gate of NMOS transistor M3), and output terminal (point of connection of the drain of PMOS transistor M2 comprising a current mirror load and the drain of NMOS transistor M4) should all logically go to the "A- potential" and match.

In fact, however, there is DC offset in operational amplifier 120, and the gate potentials of the NMOS transistors (M3 and M4) comprising a differential pair do not match.

In FIG.10, the drive capability of NMOS transistor M3 is assumed to be greater than the drive capability of NMOS transistor M4. That is to say, the channel conductance (W/L) of NMOS transistor M3 is assumed to be greater than the channel conductance of NMOS transistor M4.

Fundamentally, a current obtained by equal division of the constant current source I3 current flows in the left and right circuits of the differential pair, but if there is a difference in the current capacity of NMOS transistors M3 and M4, the current that flows through NMOS transistor M3 (I1) is greater than the current that flows through NMOS transistor M4 (I2), and the balance of the current amount of the left and right circuits is lost.

At this time, operational amplifier 120 operates to reduce this imbalance between currents I1 and I2 by means of negative feedback control.

That is to say, in the current mirror loads (M1 and M2), an output current (= I1) equal to the input current (= I1) is sent fromNMOS transistor M2. On the other hand, differential pair transistor M4 takes in only a current corresponding to current I2.

Therefore, the difference between current I1 and current I2, I4 (= I1 - I2), leaks outside the differential circuitry via a negative feedback loop (including switch SW1 in the off state), and capacitor C1 is charged. As a result, the gate voltage of NMOS transistor M4 rises.

That is to say, the gate potential of NMOS transistor M4 rises so that a larger current flows in NMOS transistor M4, which has low current capacity, and when the currents flowing through differential pair NMOS transistors M3 and M4 become equal (that is, when I1 = I2 and the current amounts in the left and right circuits are balanced), the rise of the gate potential of NMOS transistor M4 stops.

As a result, the gate potential of NMOS transistor M4 becomes higher than the gate potential of NMOS transistor M3, and a potential difference (corresponding to the operational amplifier 120 DC offset (DCoff)) occurs on either side of capacitor C1.

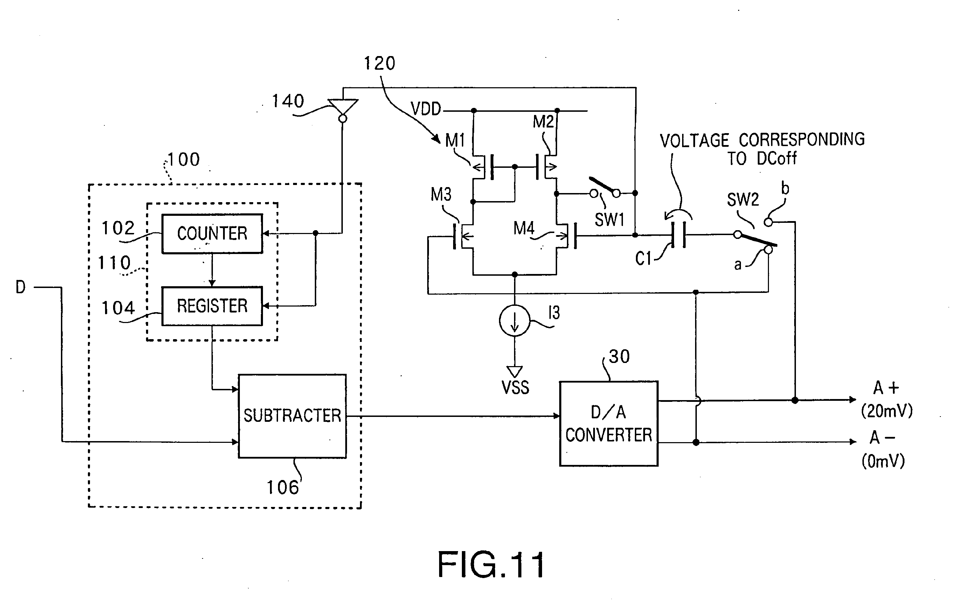

Next, as shown in FIG.11, first switch SW1 is turned off, the operational amplifier 120 negative feedback loop is terminated, and second switch SW2 is switched to the terminal b side.

When this is done, the A+ voltage is applied to the second switch SW2 side of capacitor C1 (to which A- was being applied until immediately prior thereto).

At this time, a voltage resulting from adding DC offset DCoff of operational amplifier 120 itself to A+ ((A+) + DCoff) is applied to the gate of NMOS transistor M4 (the inverse terminal of operational amplifier 120). That is to say, a corrected input analog voltage is input to the inverse terminal of operational amplifier 120.

As stated above, the current capacity of NMOS transistor M4 is lower than that of NMOS transistor M3. Thus, the voltage that should be applied to the inverse terminal in order to eliminate the resultant imbalance in left and right currents is a voltage corresponding to DCoff.

Therefore, by adding a voltage corresponding to DCoff to the input voltage (A+) beforehand, the imbalance of differential circuit left and right currents in operational amplifier 120 is automatically eliminated.

That is to say, the DC offset of operational amplifier 120 itself is masked and made indiscernible, and is canceled.

In this state, operation of counter 102 is started, and a compensation value acquisition operation is started in order to compensate for DC offset in the differential outputs of D/A converter 30.

As the DC offset of operational amplifier (comparator) 120 itself has been canceled, the DC offset of the differential outputs of D/A converter 30 is measured accurately, and a compensation value is calculated based on the measured DC offset value.

Therefore, the influence of the DC offset of operational amplifier 120 itself is eliminated, and a highly precise compensation value can be generated.

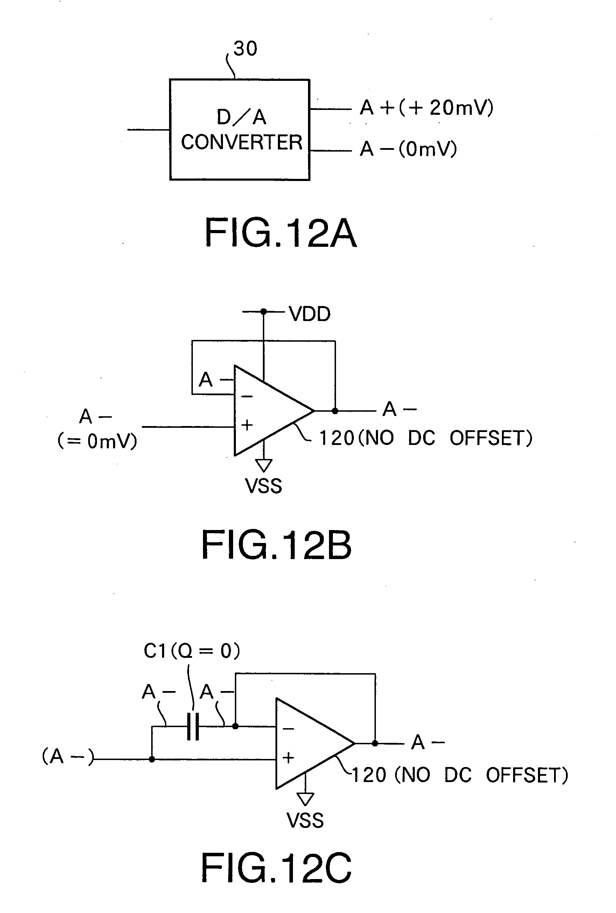

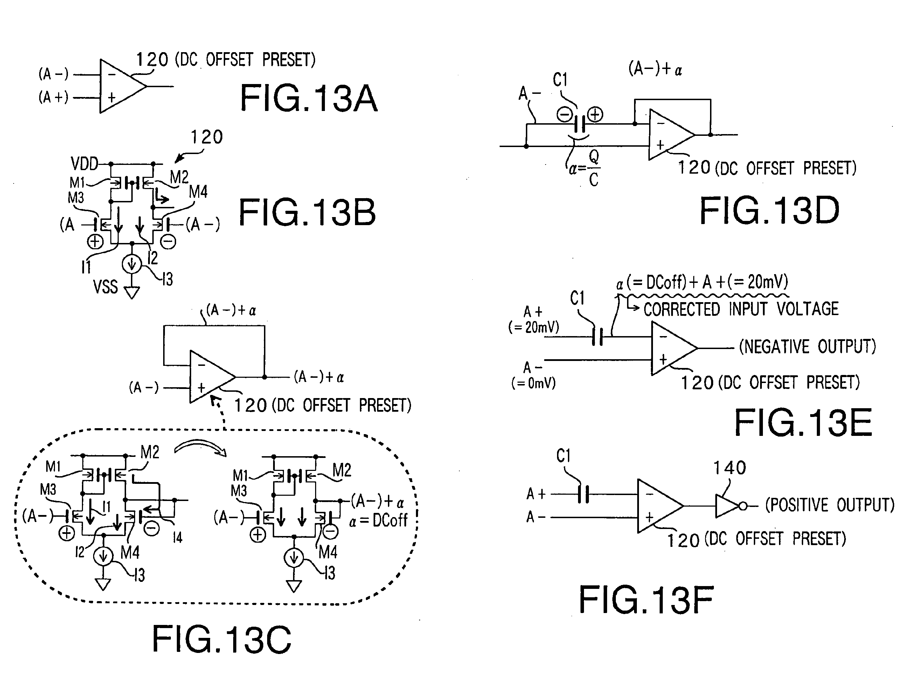

The above operations will now be summarized while referring to FIG.12 and FIG.13.

The problem considered here is how to measure accurately the DC offset between D/A converter 30 differential outputs (A- and A+), as shown in FIG.12A.

Properly, the differential outputs(A- and A+) should both be 0 V, but here, A+ is 20 mV (while A- is 0 mV), and there is a 20 mV inter-differential-output DC offset.

Before the D/A converter 30 offset is measured, it is necessary to cancel the offset of operational amplifier (comparator) 120 itself.

First, it is assumed that there is no DC offset in operational amplifier (comparator) 120 itself.

Here, as shown in FIG.12B, when an operational amplifier with no DC offset is given a voltage following configuration, and A- (= 0 mV) is input to the non-inverse terminal, inverse terminal also becomes A- due to virtual grounding, and thus the output of operational amplifier 120 also becomes A-.

Here, as shown in FIG.12C, if one side of capacitor C1 is connected to the inverse terminal of operational amplifier 120, and the other side is connected to the non-inverse terminal, the potential on either side of capacitor C1 is A-, and there is no potential difference.

Next, a case is considered in which DC offset is present in operational amplifier 120 itself, as shown in FIG.13A.

The expression "DC offset is present in operational amplifier 120 itself" means that when the inverse terminal and non-inverse terminal are made the same potential (= A-) as shown in FIG.13B, the current amounts of currents I1 and I2 of the left and right differential circuitry are different. Here, I1 > I2.

Next, operational amplifier 120 is given a voltage following configuration, as shown in FIG.13C.

When this is done, the voltage of the inverse terminal of compensation value generation section 12 rises so as to eliminate the imbalance between currents I1 and I2, as shown in the drawing enclosed by a dotted line in the lower part of FIG.13C. In the figure, this raised voltage is denoted by reference character "α". This voltage α corresponds to the DC offset DCoff of operational amplifier 120 itself.

Here, when a configuration such as shown in FIG.13D is set, a potential difference of voltage α occurs on either side of capacitor C1. Here, α = Q/C (Q: charge, C: capacitance of capacitor C1).

Next, as shown in FIG.13E, the input voltage to the inverse terminal of operational amplifier 120 is switched from A- (=0mV) to A+ (=20mV). In this case, still, the potential difference of voltage α is kept in capacitor C1.

Then α is added to original input A+ at the inverse terminal of operational amplifier 120, and the analog voltage input to the inverse terminal is corrected.

Thus voltage α is necessary to eliminate the imbalance of differential circuit left and right currents in operational amplifier 120, as shown in FIG.13C (that is to say, voltage α is a voltage equivalent to DCoff). Therefore, the DC offset of operational amplifier 120 is automatically canceled by adding this voltage α to the input analog voltage beforehand.

However, in FIG.13E, A+ (20 mV) is input to the inverse terminal of operational amplifier 120, and therefore the polarity of the operational amplifier 120 output is inverted.

Thus, the polarity is inverted by inverter 140, as shown in FIG.13F. By this means, D/A converter 30 inter-differential-output DC offset "+20 mV" (see FIG.12A) is determined accurately.

Thus a compensation value is calculated by accurately determining the DC offset between D/A 30 converter differential outputs. Consequently, it is possible to accurately compensate for DC offset between D/A 30 converter differential outputs.

Thus, according to this embodiment, a capacitor is connected to the inverse terminal of the operational amplifier, and the input voltage is stepped up (or stepped down) by using this capacitor as a bootstrap capacitor.

The point to be noted here is that, in this embodiment, the voltage is not simply stepped up (stepped down), but the amount of change of the voltage is made to match the DC offset of the operational amplifier itself, whereby the analog voltage input to the inverse input terminal of the operational amplifier is corrected beforehand so that the DC offset of the operational amplifier can be canceled.

That is to say, in this embodiment, a capacitor functions as a means of correcting the inverse terminal input voltage. Then, such operation is implemented solely by means of simple control comprising appropriate switching of switches, as described using FIG.9 through FIG.13.

Also, the configuration of this embodiment can be implemented by adding a capacitor and switches to the operational amplifier. The configuration is thus extremely simple, and implementation is easy.

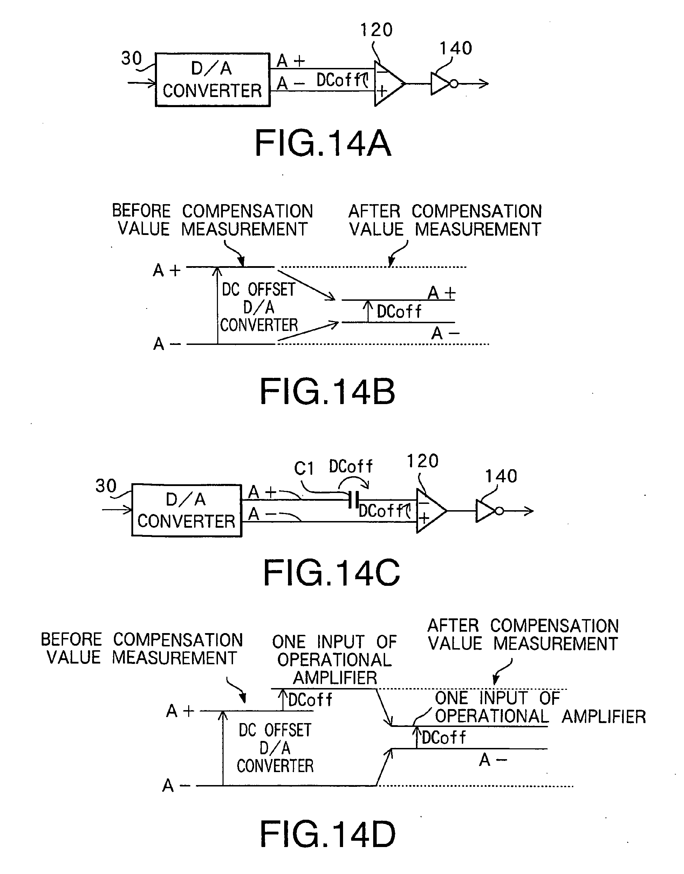

The above-described features of this embodiment are summarized in FIGS.14A through 14D.

First, an explanation will be given concerning a compensation value (a compensation value for compensating for D/A converter DC offset) in a case where operational amplifier 120 DC offset compensation is not performed, using FIGS.14A and 14B.

Here, FIG.14A shows the connection of D/A converter 30, operational amplifier 120, and inverter 140 in the case of an operational amplifier for which there is no DC offset compensation, and FIG.14B shows the potentials of D/A converter outputs A+ and A- before compensation value measurement and the potentials of A+ and A- after compensation value measurement.

In this case, "DC offset compensation value × 2LSB (where LSB is equivalent to 1 mV)" is "D/A converter DC offset - operational amplifier DC offset (DCoff)", and there is an amount of error equivalent to DCoff.

Next, an explanation will be given concerning a compensation value (a compensation value for compensating for D/A converter DC offset) in a case where operational amplifier 120 DC offset compensation is performed, using FIGS.14C and 14D.

Here, FIG.14C shows the connection of D/A converter 30, capacitor C1, operational amplifier 120, and inverter 140 in the case of an operational amplifier for which there is DC offset compensation, and FIG.14D shows the potentials of D/A converter outputs A+ and A- and the potentials of the operational amplifier inputs before compensation value measurement, and the potentials of the operational amplifier inputs after compensation value measurement.

In this case, "DC offset compensation value × 2LSB" is "D/A converter DC offset + operational amplifier DC offset (DCoff) - DCoff", and operational amplifier 120 DC offset is canceled, leaving the DC offset of D/A converter 30 itself, thereby enabling the DC offset of D/A converter 30 to be measured accurately.

### (Embodiment 4)

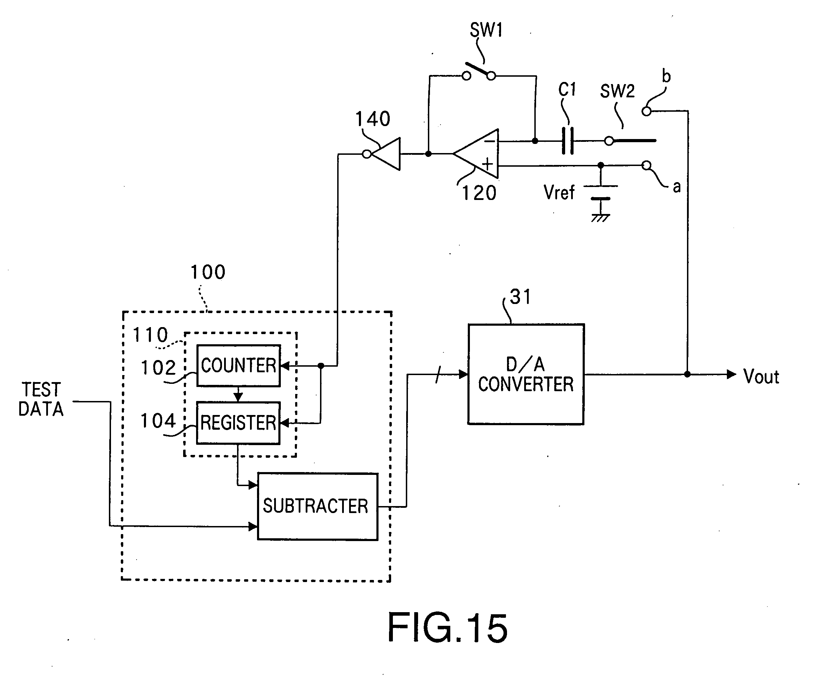

FIG.15 shows a configuration whereby output voltage Vout of a single output type D/A converter 31 is compared with a reference voltage (corresponding to the output voltage of an ideal D/A converter).

The basic configuration is the same as that of the previous embodiments, but the configuration differs in that the non-inverse terminal of operational amplifier 120 is connected to a reference voltage (Vref). It is here assumed that D/A converter 31 output voltage Vout is a positive-phase output with respect to digital input data.

The operation is fundamentally similar to that of Embodiment 3. However, a difference is that, as explained earlier, the compensation value for a single output type D/A conversion apparatus is twice the compensation value for a differential output type D/A conversion apparatus.

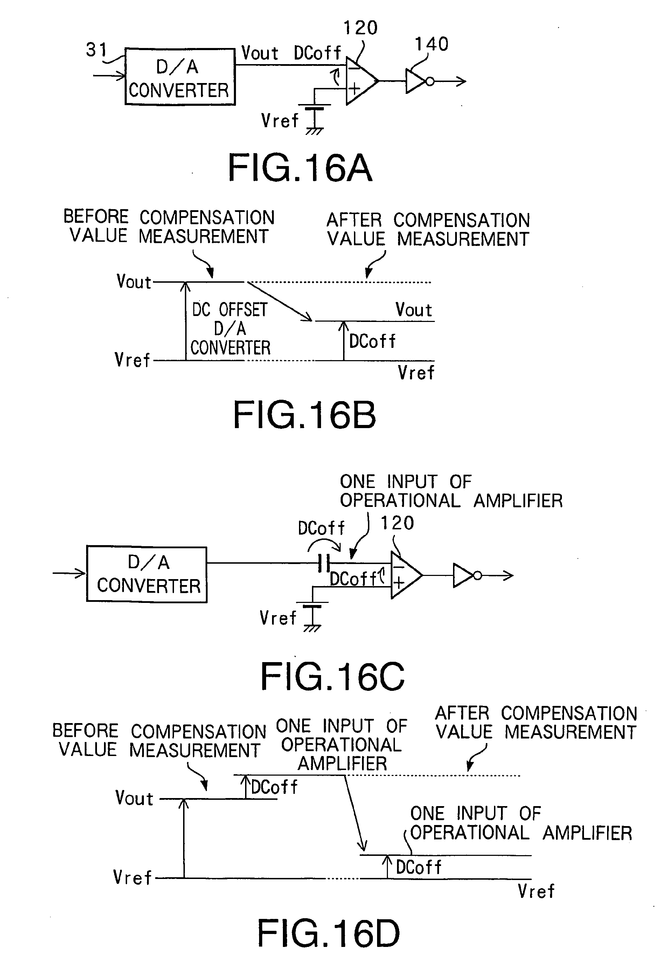

Using FIG. 16, explanations will be given concerning the DC offset compensation value in the case of an operational amplifier for which there is no DC offset compensation, and in the case of an operational amplifier for which there is DC offset compensation.

FIG.16A shows the connection of D/A converter 31, operational amplifier 120, and inverter 140 in the case of an operational amplifier for which there is no DC offset compensation, and FIG.16B shows the potential of D/A converter 31 output Vout and the potential of Vref before compensation value measurement, and the potentials of Vout and Vref after compensation value measurement.

At this time, "DC offset compensation value × LSB" is the DC offset (DCoff) of operational amplifier 120 of D/A converter 31, and there is an amount of error equivalent to DCoff.

FIG.16C shows the connection of D/A converter 31, capacitor C1, operational amplifier 120, and inverter 140 in the case of an operational amplifier for which there is DC offset compensation, and FIG.16D shows the potential of D/A converter 31 output Vout, the potential of Vref, the operational amplifier input potential before compensation value measurement, and the operational amplifier input potential after compensation value measurement.

Therefore, as shown in FIG.16D, "DC offset compensation value × LSB" can be expressed as "D/A converter DC offset + operational amplifier DC offset (DCoff) - DCoff". Operational amplifier 120 DC offset is canceled, leaving the DC offset of D/A converter 31 itself, thereby enabling the DC offset of D/A converter 31 to be measured accurately.

### (Embodiment 5)

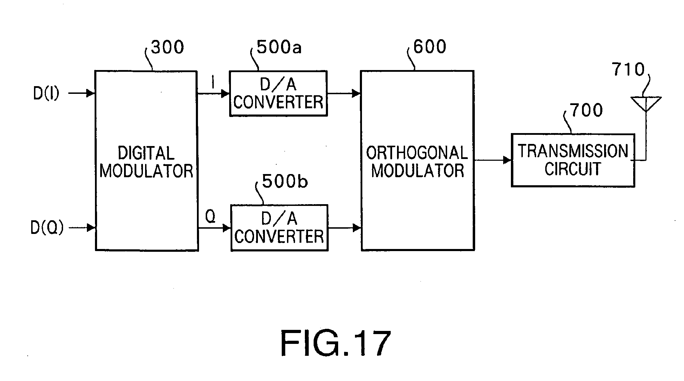

FIG.17 is a block diagram showing the configuration of a digital radio transmitter that uses a D/A conversion apparatus with an offset compensation function of the present invention.

As shown in the figure, the digital radio transmitter has a digital modulator 300, D/A conversion apparatuses (which are D/A conversion apparatuses with an offset compensation function of the present invention) 500a and 500b corresponding to I and Q respectively, an orthogonal modulator 600, a transmission circuit 700, and an antenna 710. Digital modulator 300 is a QPSK modulator, for example.

Digital modulator 300, D/A conversion apparatuses 500a and 500b, orthogonal modulator 600, and transmission circuit 700 are integrated in a single LSI.

As DC offset has been canceled, the input/output characteristics of the two D/A conversion apparatuses 500a and 500b match, and the phases of the I and Q transmit signals match, making possible accurate transmission.

A D/A conversion apparatus with an offset compensation function of the present invention can be used not only for communication, but also in audio equipment, etc.

According to the above-described invention, it is possible to almost completely eliminate D/A converter DC offset even when DC offset is present in a comparator. Also, the configuration of this invention is simple and the control method is also simple, and therefore implementation is easy. Moreover, as analog circuitry becomes finer, comparator DC offset will increase. Thus, the present invention is extremely effective as a means of implementing a D/A converter from which DC offset is almost completely eliminated, using a fine process.

The present invention is not limited to the above-described embodiments, and various variations and modifications may be possible without departing from the scope of the present invention.

This application is based on Japanese Patent Application No.2003-004041 filed on January 10, 2003, entire content of which is expressly incorporated by reference herein.

## Claims

1. A D/A conversion apparatus with an offset compensation function that detects D/A converter(30) DC offset using a comparator, finds a compensation value basedon an output signal of said comparator (50), corrects input data by performing addition or subtraction of said compensation value to/from input data, and thereby compensates for said DC offset; said D/A conversion apparatus with an offset compensation function comprising:
a changeover switch for selecting a first input mode in which a first and second signal respectively are input to a first and second input terminal of said comparator (50), and a second input mode in which said second and first signals respectively are input to said first and second input terminals of said comparator(50);
a polarity inversion section that inverts polarity of an output signal of said comparator (50) only when said second input mode is selected by means of this changeover switch(40); and
an input data correction section(10) that in said first input mode finds a first compensation value based on an output signal of said comparator (50), in said second input mode finds a second compensation value based on a signal resulting from inversion of an output signal of said comparator by said polarity inversion section (60), then finds an average compensation value by calculating an average of said first and second compensation values, and also performs correction of said input data using calculated said average compensation value.

2. The D/A conversion apparatus with an offset compensation function according to claim 1, wherein:
said D/A converter (30) is a differential output type that outputs two analog signals whose phases differ by 180°; and
these two analog signals are said first and second signals respectively in said changeover switch(40).

3. The D/A conversion apparatus with an offset compensation function according to claim 1, wherein an output signal of a single output type D/A converter(30) and a predetermined reference voltage are said first and second signals respectively in said changeover switch(40).

4. The D/A conversion apparatus with an offset compensation function according to claim 1, wherein DC offset is present in said comparator(50) itself, said D/A converter(30) DC offset and DC offset of said comparator(50) itself are both compensated for by correction of said input data, and thereby said comparator(50) functions as a comparator in which there is essentially no DC offset.

5. A D/A conversion apparatus with an offset compensation function that detects D/A converter (30) DC offset using a comparator (50), finds a compensation value based on an output signal of said comparator (50), corrects input data by performing addition or subtraction of said compensation value to/from input data, and thereby compensates for said DC offset; and that uses as said comparator(50) a self-compensating comparator that has a function that cancels DC offset of this comparator(50) itself;
wherein said self-compensating comparator(120) comprises:
an operational amplifier;
a buffer or inverter;
a first switch for switching between connection and disconnection between an output terminal and inverse terminal of this operational amplifier;
a capacitor of which one side is connected to said inverse terminal of said operational amplifier; and
a second switch for switching between connection and disconnection between another output of this capacitor and a non-inverse terminal of said operational amplifier.

6. The D/A conversion apparatus with an offset compensation function according to claim 5, wherein before a compensation value for canceling said D/A converter (30) DC offset is found, an offset cancellation operation is executed for said self-compensating comparator(120); and also
when this offset cancellation operation for said self-compensating comparator is executed:
first, said first switch is turned on, and said output terminal and said input terminal of said operational amplifier are shorted and voltage following by means of 100% negative feedback is configured, and also another terminal of said capacitor and said non-inverse terminal of said operational amplifier are connected by said second switch and that connection point is made a predetermined potential, whereby a voltage corresponding to a DC offset of said operational amplifier is generated on both sides of said capacitor;
then said first switch is turned off and said output terminal and said inverse terminal of said operational amplifier are disconnected, and also said other terminal of said capacitor is disconnected from said non-inverse terminal of said operational amplifier by means of said second switch;
and then a signal necessary for measuring DC offset of said D/A converter is supplied to said other terminal of said capacitor and said non-inverse terminal of said operational amplifier, and at this time DC offset of said operational amplifier is canceled with a voltage corresponding to DC offset of said operational amplifier generated by said capacitor.

7. An LSI incorporating the D/A conversion apparatus with an offset compensation function according to claim 1.

8. A D/A conversion apparatus offset compensation method that detects D/A converter(30) DC offset using a comparator (50), finds a compensation value basedon an output signal of said comparator (50), corrects input data by performing addition or subtraction of said compensation value to/from input data, and thereby compensates for said DC offset; said D/A conversion apparatus offset compensation method comprising:
a step of inputting a first and second signal respectively to a first and second input terminal of said comparator, and finding a first compensation value based on an output signal of said comparator(50);
a step of inputting said second and first signal respectively to said first and second input terminal of said comparator(50), and finding a second compensation value based on a signal resulting from inversion of an output signal of said comparator by said polarity inversion section(60);
a step of finding an average compensation value by calculating an average of said first and second compensation values; and
a step of performing correction of input data using this average compensation value.

9. A D/A conversion apparatus offset compensation method whereby offset cancellation is performed via the operation according to claim 6 for said self-compensating comparator constituent to the D/A conversion apparatus according to claim 5, then said compensation value is found using that self-compensating comparator(50) for which DC offset has been canceled, input data correction is performed using this compensation value, and thereby said D/A converter(30) DC offset is compensated for.
